# EUROPEAN PATENT APPLICATION

(11) **EP 4 648 583 A1**
(43) Date of publication of application: **12.11.2025**
(21) Application number: 24766257.0
(22) Date of filing: 20.02.2024
(51) Int. Cl.: H10K 30/87, H10K 30/40, H10K 30/50, H10K 71/00

(54) **PEROVSKITE CELL AND MANUFACTURING METHOD THEREFOR, AND ELECTRIC APPARATUS**

(30) Priority: 09.03.2023 CN 202310218954
(71) Applicant: Contemporary Amperex Technology Co., Limited, Ningde, Fujian 352100 (CN)
(72) Inventor: LI, Hanfang, Ningde, Fujian 352100 (CN); SU, Shuojian, Ningde, Fujian 352100 (CN); LIN, Xiangling, Ningde, Fujian 352100 (CN); ZHANG, Fan, Ningde, Fujian 352100 (CN); LIU, Zhaohui, Ningde, Fujian 352100 (CN); GUO, Yongsheng, Ningde, Fujian 352100 (CN); CHEN, Guodong, Ningde, Fujian 352100 (CN)
(74) Representative: Frick, Robert
(86) International application number: PCT/CN2024/077754
(87) International publication number: WO 2024/183535

(57) **Abstract**

This application relates to the technical field of solar cells, specifically to a perovskite battery and a preparation method thereof, and an electric apparatus. The perovskite battery includes: a first electrode layer configured to be an electrode layer for light incidence in the perovskite battery; a first carrier transport layer disposed on the first electrode layer, the first carrier transport layer being one of a hole transport layer and an electron transport layer; a perovskite layer disposed on a side of the first carrier transport layer facing away from the first electrode layer; a second electrode layer located on a side of the perovskite layer facing away from the first electrode layer; and a first functional layer located on a side of the perovskite layer facing away from the first carrier transport layer and on a side of the second electrode layer in a thickness direction, where the first functional layer is capable of reflecting at least a portion of light incident from the first electrode layer and transmitted through the perovskite layer back to the perovskite layer. This application achieves high light utilization efficiency and enhances the photoelectric conversion efficiency of the perovskite battery.

## Description

### CROSS-REFERENCE TO RELATED APPLICATIONS

This application claims priority to Chinese Patent Application No. 2023102189549, filed on March 9, 2023 and entitled "PEROVSKITE BATTERY AND PREPARATION METHOD THEREOF, AND ELECTRIC APPARATUS", which is incorporated herein by reference in its entirety.

### TECHNICAL FIELD

This application relates to the technical field of solar cells, and more particularly, to a perovskite battery and a preparation method thereof, and an electric apparatus.

### BACKGROUND

In recent years, with the rapid development of solar cell technology, perovskite batteries have become a highly regarded type of battery. Perovskite batteries possess advantages such as high conversion efficiency, simple preparation, wide availability of materials, and low cost, offering broad application prospects. However, in perovskite batteries of related technologies, the photoelectric conversion efficiency of perovskite batteries remains relatively low.

### SUMMARY

In view of this, to address the issue of relatively low photoelectric conversion efficiency in perovskite batteries of related technologies, providing a perovskite battery and a preparation method thereof, and an electric apparatus becomes necessary.

According to a first aspect, this application provides a perovskite battery including:
a first electrode layer configured to be an electrode layer for light incidence in the perovskite battery;
a first carrier transport layer disposed on the first electrode layer, the first carrier transport layer being one of a hole transport layer and an electron transport layer;
a perovskite layer disposed on a side of the first carrier transport layer facing away from the first electrode layer;
a second electrode layer located on a side of the perovskite layer facing away from the first electrode layer; and
a first functional layer located on a side of the perovskite layer facing away from the first electrode layer and on a side of the second electrode layer in a thickness direction, the first functional layer being capable of reflecting at least a portion of light incident from the first electrode layer and transmitted through the perovskite layer back to the perovskite layer.

In the above solution, by disposing the first functional layer on a side of the perovskite layer facing away from the first electrode layer, where the first functional layer is capable of reflecting at least a portion of light incident from the first electrode layer and transmitted through the perovskite layer back to the perovskite layer, light not fully absorbed by the perovskite layer can be reintroduced into the perovskite layer, thereby increasing light utilization efficiency and improving the photoelectric conversion efficiency of the perovskite battery.

In some embodiments, a material of the first functional layer includes at least one of the following materials:
TiO2, ZnO, SnO2, Al2O3, MoO3, WO3, NiOx, ITO, FTO, AgBiS2, WS2, MoS2, LiF, MgF2, NaF, KF, Au, Ag, Cu, Al, and Cr.

By adopting the above materials, the first functional layer can reflect light not fully utilized by the perovskite layer back to the perovskite layer, thereby improving light utilization efficiency. Additionally, the first functional layer maintains stable properties, isolating the second carrier transport layer material from water, oxygen, and dust in the environment and preventing contact reactions, thus enhancing the stability of the perovskite battery.

In some embodiments, a thickness of the first functional layer ranges from 0.5 nm to 20 nm.

With such a thickness, the first functional layer not only achieves a favorable reflection effect for light transmitted through the perovskite layer but also sufficiently prevents reactions between the second electrode layer and the second carrier transport layer, improving interface contact and reducing charge accumulation at the interface.

In some embodiments, the perovskite battery further includes a second carrier transport layer disposed between the perovskite layer and the second electrode layer, the second carrier transport layer being the other of the hole transport layer and the electron transport layer;
where the first functional layer is disposed between the perovskite layer and the second carrier transport layer; or
the first functional layer is disposed between the second carrier transport layer and the second electrode layer; or
the first functional layer is disposed on a side of the second electrode layer facing away from the second carrier transport layer; or
the first functional layer is disposed both between the perovskite layer and the second carrier transport layer and between the second carrier transport layer and the second electrode layer; or
the first functional layer is disposed both between the perovskite layer and the second carrier transport layer and on a side of the second electrode layer facing away from the second carrier transport layer; or
the first functional layer is disposed both between the second carrier transport layer and the second electrode layer and on a side of the second electrode layer facing away from the second carrier transport layer; or
the first functional layer is disposed between the perovskite layer and the second carrier transport layer, between the second carrier transport layer and the second electrode layer, and on a side of the second electrode layer facing away from the second carrier transport layer.

The position of the first functional layer can be flexibly configured according to actual needs, thereby enhancing the design flexibility of the perovskite battery.

In some embodiments, the first functional layer is disposed between the second carrier transport layer and the second electrode layer; where
the second electrode layer includes a second functional layer and a first metal layer stacked on a side of the first functional layer facing away from the second carrier transport layer, the second functional layer being configured to block migration of iodine ions from the perovskite layer to the first metal layer.

In the above solution, the second electrode layer includes the second functional layer and the first metal layer stacked on a side of the first functional layer facing away from the second carrier transport layer; in other words, the second functional layer is located between the first functional layer and the first metal layer, thereby positioning the second functional layer to block between the perovskite layer and the first metal layer.

Due to the good conductivity and stable properties of the second functional layer, migration of iodine ions from the perovskite layer to the first metal layer is prevented; furthermore, the first metal layer serves the function of charge transport, thus effectively preventing reactions between the second electrode layer and iodine ions in the perovskite layer that could lead to failure of the perovskite battery while ensuring charge transport.

In some embodiments, a material of the second functional layer includes at least one of the following materials:
ITO, FTO, LiF, MgF2, and MoO3.

By adopting the above materials, the stability of the second functional layer is enhanced, effectively preventing migration of iodine ions from the perovskite layer, reducing defects and recombination sites at the interface, and improving efficiency while increasing the long-term stability of the perovskite battery.

In some embodiments, a thickness of the second functional layer ranges from 5 nm to 30 nm.

With such a thickness, the second functional layer not only effectively blocks iodine ions in the perovskite layer but also does not affect the charge transport process from the perovskite layer to the first metal layer.

In some embodiments, a surface of the perovskite layer on a side facing away from the first carrier transport layer is a rough surface.

In this manner, a surface of the perovskite layer facing away from the first carrier transport layer forms a structure with undulating heights; compared to a planar structure, this increases a surface area of the perovskite layer facing the second carrier transport layer, enlarging an absorption area for light incident on the perovskite layer, thereby increasing light utilization efficiency and improving the photoelectric conversion efficiency of the perovskite battery.

In some embodiments, a surface of the perovskite layer on a side facing away from the first carrier transport layer is provided with a plurality of recessed structures.

With recessed structures provided, portions not recessed become protruding structures relative to the recesses, thereby forming a rough surface with undulating heights on the surface of the perovskite layer.

In some embodiments, an inner contour shape of the recessed structures is an inverted pyramid shape.

In this manner, each side surface of the recessed structures is inclined toward a side of the second carrier transport layer, facilitating mold release during the fabrication of the recessed structures using a mold.

In some embodiments, a depth h1 of the recessed structures satisfies: 0 < h1 ≤ 100 nm.

When a mold is used to form recessed structures on a wet film of perovskite, a portion of the wet film enters cavities of a first mold, such as spaces between adjacent protrusions; if the depth of the recessed structures is too large or an opening edge dimension of the recessed structures is too large, an excessive amount of perovskite precursor solution may enter the cavities of the first mold, potentially resulting in areas of the first carrier transport layer not covered by the perovskite layer. By ensuring the depth h1 of the recessed structures satisfies 0 < h1 ≤ 100 nm, this situation can be effectively avoided, ensuring the entire layer of the first carrier transport layer is covered by the perovskite layer.

In some embodiments, the plurality of recessed structures are arranged in an array.

In this manner, forming recessed structures of relatively uniform size across the entire perovskite layer is facilitated.

According to a second aspect, this application provides an electric apparatus including the battery described above.

According to a third aspect, this application provides a preparation method of a perovskite battery including:
forming a first carrier transport layer on a first electrode layer;
forming a perovskite layer on a side of the first carrier transport layer facing away from the first electrode layer; and
forming a first functional layer on a side of the perovskite layer facing away from the first electrode layer; where
the first carrier transport layer is one of a hole transport layer and an electron transport layer, the first electrode layer is configured to be an electrode layer for light incidence in the perovskite battery, and the first functional layer is capable of reflecting at least a portion of light incident from the first electrode layer and transmitted through the perovskite layer back to the perovskite layer.

In the above solution, by forming the perovskite layer on a side of the first carrier transport layer facing away from the first electrode layer and forming the first functional layer on a side of the perovskite layer facing away from the first electrode layer, where the first functional layer is capable of reflecting at least a portion of light incident from the first electrode layer and transmitted through the perovskite layer back to the perovskite layer, light not fully absorbed by the perovskite layer can be reintroduced into the perovskite layer, thereby increasing light utilization efficiency and improving the photoelectric conversion efficiency of the perovskite battery.

In some embodiments, the step of forming a perovskite layer on a side of the first carrier transport layer facing away from the first electrode layer specifically includes:
spin-coating a perovskite precursor solution onto the first carrier transport layer to form an intermediate film layer of perovskite; and
covering a cavity of a first mold over the intermediate film layer of perovskite, and annealing and cooling the intermediate film layer of perovskite to form the perovskite layer with a rough surface.

In the above solution, forming the intermediate film layer of perovskite on the first carrier transport layer, covering the intermediate film layer of perovskite with the cavity of the first mold, and annealing and cooling the intermediate film layer to form the perovskite layer with a rough surface not only involves low cost but also features a relatively simple preparation process that is easy to implement.

In some embodiments, a spin-coating speed is 4000 rpm and a spin-coating duration is 20s; or
an annealing duration is 45 min, and an annealing temperature is 120°C; or
a spin-coating speed is 4000 rpm, a spin-coating duration is 20s, an annealing duration is 45 min, and an annealing temperature is 120°C.

The intermediate film layer of perovskite formed by spin-coating the perovskite precursor solution onto the first carrier transport layer is a wet film; by setting the spin-coating speed to 4000 rpm, the spin-coating duration to 20s, and/or the annealing duration to 45 min, and the annealing temperature to 120°C, the formation of recessed structures is facilitated.

In some embodiments, the cavity of the first mold is provided with a plurality of protrusions; and
the step of covering a cavity of a first mold over the intermediate film layer of perovskite, and annealing and cooling the intermediate film layer of perovskite to form the perovskite layer with a rough surface specifically includes:
covering the cavity of the first mold over the intermediate film layer of perovskite, where the protrusions are embedded into the intermediate film layer of perovskite;
annealing and cooling the intermediate film layer of perovskite; and
removing the first mold from the intermediate film layer of perovskite to form the perovskite layer with a plurality of recessed structures, where the recessed structures correspond one-to-one with the plurality of protrusions.

By embedding the protrusions formed in the cavity of the first mold into the intermediate film layer of perovskite, recessed structures are formed on a surface of the perovskite layer; portions not recessed become protruding structures relative to the recesses, thereby forming a rough surface with undulating heights on the surface of the perovskite layer.

### BRIEF DESCRIPTION OF DRAWINGS

To more clearly illustrate the technical solutions of the embodiments of this application, a brief introduction to the drawings required for use in the embodiments of this application is provided below. Obviously, the drawings described below are only some embodiments of this application; for persons of ordinary skill in the art, additional drawings can be obtained based on these drawings without creative effort.
FIG. 1 is a schematic structural diagram of a perovskite battery according to some embodiments of this application;
FIG. 2 is a schematic structural diagram of a mold for fabricating recessed structures on a perovskite layer in a perovskite battery according to some embodiments of this application;
FIG. 3 is a left view of FIG. 2;
FIG. 4 is a top view of FIG. 2;
FIG. 5 is a schematic diagram of another structure of a perovskite battery according to some embodiments of this application;
FIG. 6 is a schematic flowchart of a preparation method of a perovskite battery according to some embodiments of this application;
FIG. 7 is a schematic diagram of forming a first carrier transport layer on a first electrode layer in a preparation method of a perovskite battery according to some embodiments of this application;
FIG. 8 is a schematic diagram of forming a perovskite layer on a first carrier transport layer in a preparation method of a perovskite battery according to some embodiments of this application;
FIG. 9 is a schematic diagram of sequentially forming a second carrier transport layer and a first functional layer on a perovskite layer in a preparation method of a perovskite battery according to some embodiments of this application;
FIG. 10 is a schematic diagram of forming a second electrode layer on a first functional layer in a preparation method of a perovskite battery according to some embodiments of this application;
FIG. 11 is a schematic structural diagram of a perovskite battery prepared by another preparation method of a perovskite battery according to some embodiments of this application; and
FIG. 12 is a schematic structural diagram of a mask in Example 1 of this application.

100. perovskite battery; 10. first electrode layer; 11. glass substrate; 12. conductive layer; 20. first carrier transport layer; 30. perovskite layer; 30'. first perovskite layer; 31. recessed structure; 40. second carrier transport layer; 50. first functional layer; 60. second electrode layer; 61. second functional layer; 62. first metal layer;
70. first mold; 71. protrusion; 72. base; 73. forming portion; and 731. cavity.

### DESCRIPTION OF EMBODIMENTS

To make the above objectives, features, and advantages of this application more apparent and understandable, a detailed description of specific embodiments of this application is provided below in conjunction with the drawings. In the following description, numerous specific details are set forth to provide a thorough understanding of this application. However, this application can be implemented in many ways different from those described herein, and persons skilled in the art can make similar improvements without departing from the spirit of this application; thus, this application is not limited by the specific embodiments disclosed below.

In the description of the embodiments of this application, the orientations or positional relationships indicated by technical terms such as "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", "radial", "circumferential", and similar terms are based on the orientations or positional relationships shown in the drawings. These terms are used merely for convenience and brevity in describing the embodiments of this application and do not indicate or imply that the devices or components referred to must have specific orientations or be constructed or operated in specific orientations; therefore, these terms should not be construed as limiting the embodiments of this application.

Additionally, the terms "first" and "second" are used solely for descriptive purposes and should not be understood as indicating or implying relative importance or implicitly indicating the number of technical features specified. Thus, a feature defined by "first" or "second" may explicitly or implicitly include one or more such features. In the description of this application, "a plurality of" means at least two, such as two or three, unless otherwise specifically stated.

In this application, unless otherwise explicitly specified and defined, terms such as "mount", "connect", "join", and "fasten" should be understood in their general senses. For example, these terms may refer to a fixed connection, a detachable connection, or an integral connection; a mechanical connection or an electrical connection; a direct connection, an indirect connection via an intermediate medium, or an interaction between two elements. Persons of ordinary skill in the art can understand the specific meanings of these terms in this application based on specific contexts.

In this application, unless otherwise explicitly specified and defined, a first feature being "on" or "under" a second feature may mean direct contact between the first and second features, or indirect contact between the first and second features via an intermediate medium. Furthermore, the first feature being "above", "over", or "on" the second feature may mean that the first feature is directly above or obliquely above the second feature, or simply that the first feature is at a higher level than the second feature. The first feature being "below", "beneath", or "under" the second feature may mean that the first feature is directly below or obliquely below the second feature, or simply that the first feature is at a lower level than the second feature.

It should be noted that when an element is described as being "fixed to" or "disposed on" another element, the element may be directly fixed to the other element, or an intervening element may be present. When an element is described as being "connected to" another element, the element may be directly connected to the other element, or an intervening element may be present. Terms such as "perpendicular", "horizontal", "upper", "lower", "left", "right", and similar expressions used herein are for illustrative purposes only and do not indicate a sole embodiment.

As an important representative of new energy, solar cells are photovoltaic devices that convert light into electricity. Traditional solar cells include crystalline silicon solar cells, cadmium telluride, and copper indium gallium selenide thin-film solar cells; although these have a high market share, their preparation processes involve high pollution and energy consumption, and their power generation costs remain less competitive compared to traditional power generation methods.

As a new type of solar cell, perovskite batteries use halogen-containing perovskite as a light-absorbing layer, offering advantages such as simple preparation, wide material availability, and low cost, with very broad application prospects. However, current perovskite batteries exhibit low utilization efficiency of incident light, resulting in relatively low photoelectric conversion efficiency.

Perovskite batteries in related technologies generally include functional layers stacked sequentially: a transparent glass substrate (light incident surface), a conductive layer, a carrier transport layer, a perovskite light-absorbing layer, another carrier transport layer, and a back electrode layer. The inventors of this application found through research that light incident from the transparent glass substrate passes through each functional layer sequentially, and not all light reaching the perovskite light-absorbing layer is fully absorbed; a portion of the light is not absorbed and exits directly, causing light loss.

The inventors of this application have found through research that if light not utilized can be reflected multiple times before exiting the perovskite electronic component and absorbed by the perovskite layer, the utilization efficiency of incident light can be greatly improved, thereby enhancing the photoelectric conversion efficiency of the perovskite battery.

Based on this, this application provides a perovskite battery and a preparation method thereof, and an electric apparatus.

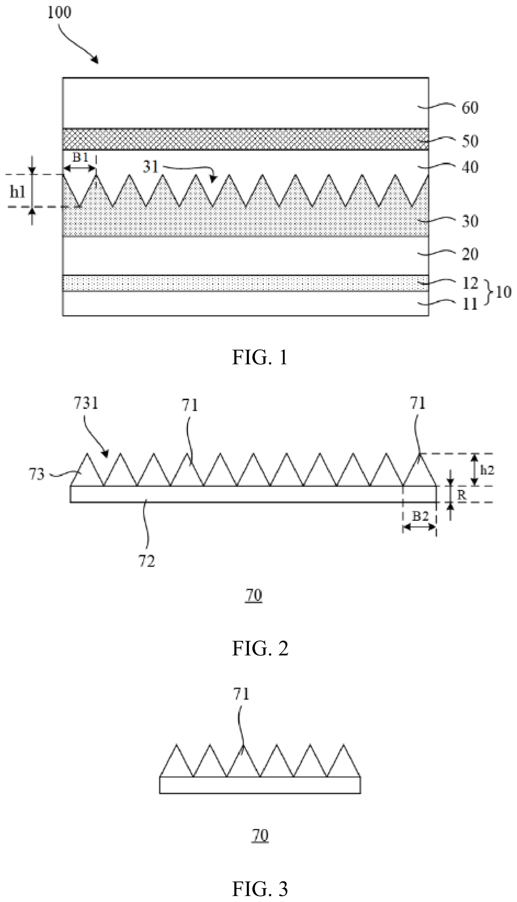

FIG. 1 is a schematic structural diagram of a perovskite battery according to some embodiments of this application.

Referring to FIG. 1, according to a first aspect, an embodiment of this application provides a perovskite battery 100 including a first electrode layer 10 configured to be an electrode layer for light incidence in the perovskite battery 100; a first carrier transport layer 20 disposed on the first electrode layer 10, the first carrier transport layer 20 being one of a hole transport layer and an electron transport layer; a perovskite layer 30 disposed on a side of the first carrier transport layer 20 facing away from the first electrode layer 10; a second electrode layer 60 located on a side of the perovskite layer 30 facing away from the first electrode layer 10; and a first functional layer 50 located on a side of the perovskite layer 30 facing away from the first electrode layer 10 and on a side of the second electrode layer 60 in a thickness direction, the first functional layer 50 being capable of reflecting at least a portion of light incident from the first electrode layer 10 and transmitted through the perovskite layer 30 back to the perovskite layer 30.

In the above solution, by disposing the first functional layer 50 on a side of the perovskite layer 30 facing away from the first electrode layer 10, where the first functional layer 50 is capable of reflecting at least a portion of light incident from the first electrode layer 10 and transmitted through the perovskite layer 30 back to the perovskite layer 30, light not fully absorbed by the perovskite layer 30 can be reintroduced into the perovskite layer 30, thereby increasing light utilization efficiency and improving the photoelectric conversion efficiency of the perovskite battery 100.

Experimental verification by the inventors of this application confirmed that in the perovskite battery 100 provided with the first functional layer 50, short-circuit current density significantly increases, the hysteresis effect of the perovskite battery 100 weakens, the difference in fill factor (FF) between forward and reverse scans is less than 3%, and the difference in photoelectric conversion efficiency (PCE) is less than 1%, indicating that the performance of the perovskite battery 100 is enhanced after adding the first functional layer 50.

The first electrode layer 10 being configured to be an electrode layer for light incidence in the perovskite battery 100 means that external light enters the perovskite battery 100 from the first electrode layer 10; and light incident from the first electrode layer 10 passes through the first carrier transport layer 20 and irradiates the perovskite layer 30, generating electron-hole pairs in the perovskite layer 30.

It should be noted that the first functional layer 50 being located on a side of the perovskite layer 30 facing away from the first electrode layer 10 means that the first functional layer 50 can be directly disposed on a side of the perovskite layer 30 facing away from the first electrode layer 10; alternatively, other functional layers may be disposed on a side of the perovskite layer 30 facing away from the first electrode layer 10, with the first functional layer located between these other functional layers. The first functional layer 50 being located on a side of the second electrode layer 60 in a thickness direction means that the first functional layer 50 can be located on a side of the second electrode layer 60 facing the first electrode layer 10 or on a side of the second electrode layer 60 facing away from the first electrode layer 10; and the thickness direction of the second electrode layer 60 specifically refers to a stacking direction of the functional layers in the perovskite battery.

For example, referring to FIG. 1, the perovskite battery 100 may further include a second carrier transport layer 40, where the second carrier transport layer 40 is disposed between the perovskite layer 30 and the second electrode layer 60, and the second carrier transport layer 40 is the other of the hole transport layer and the electron transport layer. In some embodiments, the second electrode layer 60 may be a back electrode layer. Additionally, this stacking may involve direct contact or stacking via intermediate functional layers.

It can be understood that, in the embodiments of this application, the description assumes the first carrier transport layer 20 is a hole transport layer and the second carrier transport layer 40 is an electron transport layer. However, this application is not limited to this; the first carrier transport layer 20 may be an electron transport layer, and the second carrier transport layer 40 may be a hole transport layer. The arrangement of other film layers in a perovskite battery with this structure is similar to that in the perovskite battery 100 where the first carrier transport layer 20 is a hole transport layer and the second carrier transport layer 40 is an electron transport layer, and thus is not repeated herein.

For example, the first functional layer 50 may be disposed as a continuous layer, forming a continuous film structure with an outer contour shape substantially identical to an outer contour shape of the perovskite layer 30.

Regarding the position of the first functional layer 50, the first functional layer 50 may be disposed between the second carrier transport layer 40 and the second electrode layer 60. However, this application is not limited to this; in addition to the configuration shown in FIG. 1, the following configurations (not illustrated) are possible:
the first functional layer 50 is disposed between the perovskite layer 30 and the second carrier transport layer 40; and/or the first functional layer 50 is disposed on a side of the second electrode layer 60 facing away from the second carrier transport layer 40. It can be understood that the position of the first functional layer 50 can be flexibly configured according to actual needs, enhancing the design flexibility of the perovskite battery 100.

When the first functional layer 50 is disposed between the second carrier transport layer 40 and the second electrode layer 60, the interface structure can be optimized, interface contact can be increased, and ions in the second electrode layer 60 can be prevented from passing through the second carrier transport layer 40, reacting with the perovskite layer 30, and causing degradation of the perovskite layer 30 or of the second carrier transport layer 40; and this also reduces charge accumulation at the interface, improving the long-term operational stability of the perovskite battery 100.

For example, the first electrode layer 10 is a substrate with conductive properties, including a glass substrate 11 and a conductive layer 12 disposed on the glass substrate 11.

The glass substrate 11 serves as a supporting component of the perovskite battery 100, requiring transparency and strength that meet the demands of the perovskite battery 100; materials of the glass substrate 11 include, but are not limited to, glass, PET (polyethylene terephthalate), and PI (polyimide).

The conductive layer 12 functions to conduct photo-generated carriers; a material of the conductive layer 12 may be selected from one or a combination of FTO (fluorine-doped tin oxide), ITO (indium tin oxide), and AZO (aluminum-doped zinc oxide). Among these, FTO (fluorine-doped tin oxide) provides conductivity while filtering ultraviolet light that could damage the perovskite layer 30.

The embodiments of this application use FTO conductive glass as an example for the first electrode layer 10; configurations where the first electrode layer 10 is of other types are similar and not repeated herein.

The first carrier transport layer 20 can transport holes and block electrons; a material of the first carrier transport layer 20 may be selected from one or a combination of 2,2',7,7'-tetrakis[N,N-di(4-methoxyphenyl)amino]-9,9'-spirobifluorene (Spiro-OMeTAD), poly(triarylamine) (PTAA), NiOx, poly(3,4-ethylenedioxythiophene):polystyrene sulfonate (PEDOT:PSS), and WO3.

The perovskite layer 30 being disposed on a side of the first carrier transport layer 20 facing away from the first electrode layer 10 means that the perovskite layer 30 may be disposed on the first carrier transport layer 20, or other intermediate functional layers may be disposed between the perovskite layer 30 and the first carrier transport layer 20. A thickness of the perovskite layer 30 is generally 300 nm to 600 nm.

The second carrier transport layer 40 functions to transport electrons and block holes; a material of the second carrier transport layer 40 is generally one or a combination of TiO2, SnO2, ZnO, and [6,6]-phenyl-C61-butyric acid methyl ester (PCBM).

The first functional layer 50 being capable of reflecting at least a portion of light incident from the first electrode layer 10 and transmitted through the perovskite layer 30 back to the perovskite layer 30 means that light not fully absorbed by the perovskite layer 30, after passing through the second carrier transport layer 40 to reach the first functional layer 50, has at least a portion reflected by the first functional layer 50 back to the perovskite layer 30 and reabsorbed by the perovskite layer 30, significantly improving the utilization efficiency of incident light.

A material of the second electrode layer 60 may be one or a combination of Au, Ag, Cu, Al, Ni, Cr, Bi, Pt, Mg, MoO3, ITO, FTO, and AZO.

According to some embodiments of this application, optionally, a material of the first functional layer 50 may generally be an inorganic compound or a metal. For example, the material of the first functional layer 50 includes at least one of the following materials: TiO2, ZnO, SnO2, Al2O3, MoO3, WO3, NiOx, ITO, FTO, AgBiS2, WS2, MoS2, LiF, MgF2, NaF, KF, Au, Ag, Cu, Al, and Cr. In other words, the material of the first functional layer 50 may be one or a combination of the above materials.

By adopting the above materials, the first functional layer 50 can reflect light not fully utilized by the perovskite layer 30 back to the perovskite layer 30, thereby improving light utilization efficiency. Additionally, the first functional layer 50 maintains stable properties, isolating the second carrier transport layer 40 material from water, oxygen, and dust in the environment and preventing contact reactions, thus enhancing the stability of the perovskite battery 100.

Understandably, the material of the first functional layer 50 includes, but is not limited to, the materials listed above; and other inorganic compounds and metals may also be used as long as the material has the property of reflecting at least a portion of light transmitted through the perovskite layer 30 back to the perovskite layer 30.

According to some embodiments of this application, optionally, a thickness of the first functional layer 50 ranges from 0.5 nm to 20 nm.

With such a thickness, the first functional layer 50 not only achieves a favorable reflection effect for light transmitted through the perovskite layer 30 but also sufficiently prevents reactions between the second electrode layer 60 and the second carrier transport layer 40, improving interface contact and reducing charge accumulation at the interface.

The thickness of the first functional layer 50 can be set relatively thin to achieve a lightweight and thin structure for the perovskite battery 100; if the thickness of the first functional layer 50 is less than 0.5 nm, issues with poor light reflection effectiveness or high fabrication costs may arise. Conversely, if the thickness of the first functional layer 50 exceeds 20 nm, electron transport from the perovskite layer 30 to the second electrode layer 60 may be hindered, affecting the performance of the perovskite battery 100.

In the embodiments of this application, still referring to FIG. 1, to further improve the light utilization efficiency of the perovskite layer 30, a surface of the perovskite layer 30 on a side facing away from the first carrier transport layer 20 is a rough surface.

In this manner, a surface of the perovskite layer 30 facing away from the first carrier transport layer 20 forms a structure with undulating heights; compared to a planar structure, this increases a surface area of the perovskite layer 30 facing the second carrier transport layer 40, enlarging an absorption area for light incident on the perovskite layer 30, thereby increasing light utilization efficiency and improving the photoelectric conversion efficiency of the perovskite battery 100.

In specific implementation, a surface of the perovskite layer 30 on a side facing away from the first carrier transport layer 20 may be provided with a plurality of recessed structures 31 to form a rough surface. It should be noted that the recessed structures 31 may be structures recessed from a surface of the perovskite layer 30 toward the first carrier transport layer 20. By providing the recessed structures 31, portions not recessed become protruding structures relative to the recesses, thereby forming a rough surface with undulating heights on the surface of the perovskite layer 30.

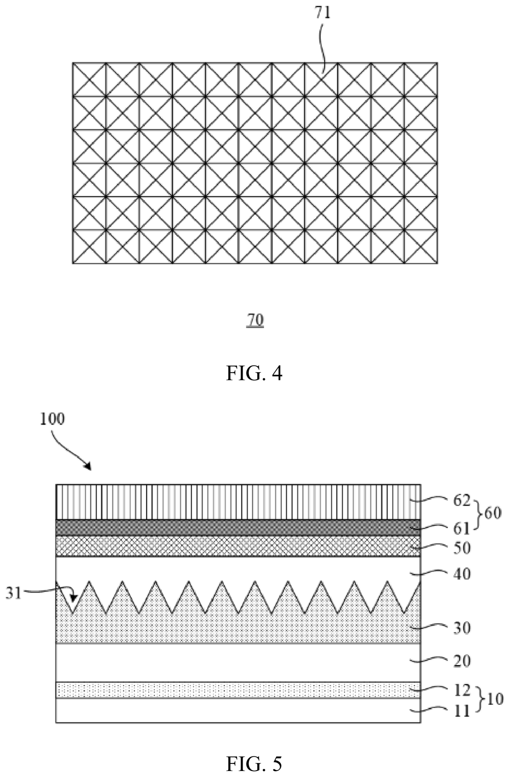

FIG. 2 is a schematic structural diagram of a mold for fabricating recessed structures on a perovskite layer in a perovskite battery according to some embodiments of this application, FIG. 3 is a left view of FIG. 2, and FIG. 4 is a top view of FIG. 2.

The aforementioned rough surface can be formed using a mold. Taking the formation of the recessed structures 31 as an example, the recessed structures can be formed using a first mold 70 as shown in FIG. 2, FIG. 3, and FIG. 4. The first mold 70 has a cavity 731 with a plurality of protrusions 71; during the preparation of the perovskite layer 30, covering a wet film of perovskite with the cavity 731 of the first mold 70, followed by steps such as annealing and cooling, allows the formation of a plurality of recessed structures 31 on a surface of the perovskite layer 30 corresponding to the positions of the plurality of protrusions 71.

Specifically, referring to FIG. 1 and FIG. 2, the first mold 70 includes a base 72 and a forming portion 73 disposed on a side surface of the base 72; the forming portion 73 is configured with a cavity 731, and the cavity 731 has a plurality of protrusions 71 protruding from a bottom surface of the cavity 731, with the number of protrusions 71 being plural. An outer contour dimension of the base 72 may be substantially identical to an outer contour dimension of the glass substrate 11, and a thickness R of the base 72 is less than 0.5 mm.

In some embodiments, a material of the first mold 70 may be corrosion-resistant PTFE (polytetrafluoroethylene).

According to some embodiments of this application, optionally, an inner contour shape of the recessed structures 31 is an inverted pyramid shape.

In this manner, each side surface of the recessed structures 31 is inclined toward a side of the first carrier transport layer 20, facilitating mold release during the fabrication of the recessed structures 31 using the first mold 70.

It should be noted that the inverted pyramid shape herein may be an inverted triangular pyramid shape, with a corresponding surface of the first mold 70 formed in a pyramid shape; alternatively, the inverted pyramid shape of the recessed structures 31 may be an inverted quadrangular pyramid shape or an inverted multi-sided pyramid shape.

According to some embodiments of this application, referring to FIG. 1, a depth h1 of the recessed structures 31 satisfies: 0 < h1 ≤ 100 nm. The depth of the recessed structures 31 refers to a distance between a deepest point of the recess and a surface of the perovskite layer 30.

Still referring to FIG. 2, understandably, when forming the recessed structures 31 by covering a wet film of perovskite with a mold, a portion of the wet film enters the cavity 731 of the first mold 70, such as spaces between adjacent protrusions 71; if the depth of the recessed structures 31 is too large or an opening edge dimension of the recessed structures 31 is too large, an excessive amount of perovskite precursor solution may enter the cavity 731 of the first mold 70, potentially resulting in areas of the first carrier transport layer 20 not covered by the perovskite layer 30. By ensuring the depth h1 of the recessed structures 31 satisfies 0 < h1 ≤ 100 nm, this situation can be effectively avoided, ensuring the entire layer of the first carrier transport layer 20 is covered by the perovskite layer 30.

Further, an inner contour shape of the recessed structures 31 is configured as an inverted quadrangular pyramid shape; when the depth h1 of the recessed structures 31 satisfies 0 < h1 ≤ 100 nm, an opening edge length B1 of the recessed structures 31 can be less than 100 nm. The opening edge length of the recessed structures 31, in the case where the inner contour shape is an inverted quadrangular pyramid, refers to a base edge length of the inverted quadrangular pyramid. For example, the opening edge length B1 may be 50 nm, achieving effects such as improved grain boundary quality and increased short-circuit current density Jsc.

Understandably, to ensure the inner contour shape of the recessed structures 31 is an inverted quadrangular pyramid shape, the protrusions 71 may be quadrangular pyramid structures. To ensure the depth h1 of the recessed structures 31 satisfies 0 < h1 ≤ 100 nm and the opening edge length B1 of the recessed structures 31 is less than 100 nm, referring to FIG. 2 and FIG. 3, a protrusion height range of the protrusions 71 may satisfy: 0 < h2 ≤ 100 nm, and a base edge length B2 of the protrusions 71 is less than 100 nm.

When the protrusion height h2 is 20 nm (corresponding to h1 of 20 nm), the recessed structures 31 formed after annealing the perovskite layer 30 prevent widening of grain boundaries between crystal grains, facilitating the formation of a flat and dense light-absorbing layer, avoiding gaps between grains that could lead to leakage current. The protrusion height h2 may alternatively be 60 nm (corresponding to h1 of 60 nm), allowing recesses to form between crystal grains of the perovskite layer 30 without penetrating to contact a lower surface; and such deep recesses reduce a longitudinal transport distance of carriers, improving carrier transport efficiency and reducing recombination probability at the interface, effectively enhancing the short-circuit current density Jsc and fill factor FF of the device.

According to some embodiments of this application, the plurality of recessed structures 31 are arranged in an array. In other words, the recessed structures 31 are arranged in rows and columns on a surface of the perovskite layer 30. In this manner, forming recessed structures 31 of relatively uniform size across the entire perovskite layer 30 is facilitated. It should be noted that in the embodiments of this application, the description assumes a surface of the first mold 70 has 6 rows and 11 columns of protrusions 71, meaning a surface of the perovskite layer 30 has 66 recessed structures 31 as an example; however, the number of recessed structures 31 is not limited to this and may be set as needed.

FIG. 5 is a schematic diagram of another structure of a perovskite battery according to some embodiments of this application.

According to some embodiments of this application, referring to FIG. 5, when the first functional layer 50 is disposed between the second carrier transport layer 40 and the second electrode layer 60, the second electrode layer 60 includes a second functional layer 61 and a first metal layer 62 stacked on a side of the first functional layer 50 facing away from the second carrier transport layer 40, the second functional layer 61 being configured to block migration of iodine ions from the perovskite layer 30 to the first metal layer 62.

In perovskite batteries of related technologies, iodine ions in the perovskite layer easily migrate to a back electrode layer, where metal ions in the back electrode layer react with the iodine ions, leading to oxidation and corrosion of the back electrode layer, causing failure of the perovskite battery. In the above solution, the second electrode layer 60 includes the second functional layer 61 and the first metal layer 62 stacked on a side of the first functional layer 50 facing away from the second carrier transport layer 40; in other words, the second functional layer 61 is located between the first functional layer 50 and the first metal layer 62, positioning the second functional layer 61 to block between the perovskite layer 30 and the first metal layer 62.

Due to the good conductivity and stable properties of the second functional layer 61, migration of iodine ions from the perovskite layer 30 to the first metal layer 62 is prevented; additionally, the first metal layer 62 serves the function of charge transport, thus effectively preventing reactions between the second electrode layer 60 and iodine ions in the perovskite layer 30 that could lead to failure of the perovskite battery 100 while ensuring charge transport.

As described above, the second electrode layer 60 is configured as a dual-layer structure, where the second functional layer 61 in contact with the second carrier transport layer 40 acts as a protective layer and the first metal layer 62 serves as a conductive layer.

According to some embodiments of this application, a material of the second functional layer 61 includes at least one of the following materials: ITO, FTO, LiF, MgF2, and MoO3.

By adopting the above materials, the stability of the second functional layer 61 is enhanced, effectively preventing migration of iodine ions from the perovskite layer 30, reducing defects and recombination sites at the interface, and improving efficiency while increasing the long-term stability of the perovskite battery 100.

According to some embodiments of this application, optionally, a thickness of the second functional layer 61 ranges from 5 nm to 30 nm.

With such a thickness, the second functional layer 61 not only effectively blocks iodine ions in the perovskite layer 30 but also does not affect the charge transport process from the perovskite layer 30 to the first metal layer 62.

According to some embodiments of this application, optionally, a material of the first metal layer 62 may be a metal material, including but not limited to Ag, Cu, Au, Al, Ni, and Cr.

According to some embodiments of this application, referring to FIG. 1 and FIG. 5, the perovskite battery 100 in the embodiments of this application includes: a first electrode layer 10; a first carrier transport layer 20 disposed on the first electrode layer 10; a perovskite layer 30 disposed on a side of the first carrier transport layer 20 facing away from the first electrode layer 10; and a first functional layer 50 located on a side of the perovskite layer 30 facing away from the first electrode layer 10, the first functional layer 50 being capable of reflecting at least a portion of light incident from the first electrode layer 10 and transmitted through the perovskite layer 30 back to the perovskite layer 30. By disposing the first functional layer 50, light not fully absorbed by the perovskite layer 30 can be reintroduced into the perovskite layer 30, increasing light utilization efficiency and improving the photoelectric conversion efficiency of the perovskite battery 100. A surface of the perovskite layer 30 on a side facing away from the first carrier transport layer 20 is a rough surface; for example, a surface of the perovskite layer 30 on a side facing away from the first carrier transport layer 20 is provided with a plurality of recessed structures 31. In this manner, a structure with undulating heights is formed on a surface of the perovskite layer 30; compared to a planar structure, this increases a surface area of the perovskite layer 30, enlarging an absorption area for light incident on the perovskite layer 30, further improving the photoelectric conversion efficiency of the perovskite battery 100. Additionally, the second electrode layer 60 includes a second functional layer 61 and a first metal layer 62; the second functional layer 61 and the first metal layer 62 are stacked on a side of the first functional layer 50 facing away from the second carrier transport layer 40. This positions the second functional layer 61 to block between the perovskite layer 30 and the first metal layer 62, preventing migration of iodine ions from the perovskite layer 30 to the first metal layer 62, effectively avoiding reactions between the second electrode layer 60 and iodine ions in the perovskite layer 30 that could lead to failure of the perovskite battery 100.

According to a second aspect, an embodiment of this application further provides an electric apparatus including the battery according to any one of the above solutions.

It should be noted that the battery disclosed in this application may be used in, but is not limited to, electric apparatuses such as vehicles, ships, or aircraft. A power supply system of the electric apparatus may be composed of the battery disclosed in this application.

In the electric apparatus using the battery as a power source provided by the embodiments of this application, the electric apparatus may be, but is not limited to, a mobile phone, tablet, laptop, electric toy, electric tool, electric bicycle, electric vehicle, ship, spacecraft, or space station. The electric toy may include a fixed or mobile electric toy, such as a gaming console, electric car toy, electric ship toy, or electric airplane toy.

According to a third aspect, an embodiment of this application further provides a preparation method of a perovskite battery, where the preparation method is used for preparing the perovskite battery 100 according to any one of the above solutions.

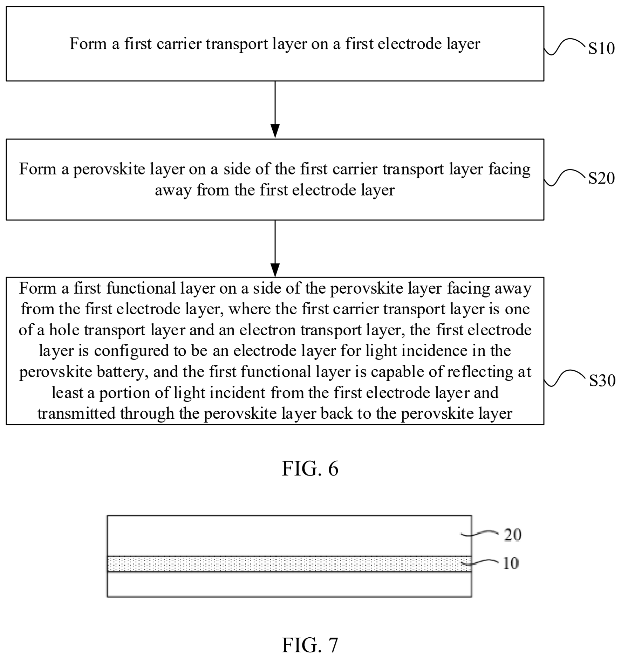

FIG. 6 is a schematic flowchart of a preparation method of a perovskite battery according to some embodiments of this application.

Referring to FIG. 1 and FIG. 6, the preparation method of a perovskite battery in this embodiment includes:
S10: Form a first carrier transport layer on a first electrode layer;
S20: Form a perovskite layer on a side of the first carrier transport layer facing away from the first electrode layer;
S30: Form a first functional layer on a side of the perovskite layer facing away from the first electrode layer.

The first electrode layer is configured to be an electrode layer for light incidence in the perovskite battery, and the first functional layer is capable of reflecting at least a portion of light incident from the first electrode layer and transmitted through the perovskite layer back to the perovskite layer.

In the above solution, by forming the perovskite layer 30 on a side of the first carrier transport layer 20 facing away from the first electrode layer 10 and forming the first functional layer 50 on a side of the perovskite layer 30 facing away from the first electrode layer 10, where the first functional layer 50 is capable of reflecting at least a portion of light incident from the first electrode layer 10 and transmitted through the perovskite layer 30 back to the perovskite layer 30, light not fully absorbed by the perovskite layer 30 can be reintroduced into the perovskite layer 30, thereby increasing light utilization efficiency and improving the photoelectric conversion efficiency of the perovskite battery 100.

The first electrode layer 10 is a substrate with conductive properties, including a glass substrate 11 and a conductive layer 12 disposed on the glass substrate 11.

The glass substrate 11 serves as a supporting component of the perovskite battery 100, requiring transparency and strength that meet the demands of the perovskite battery 100; materials of the glass substrate 11 include, but are not limited to, glass, PET (polyethylene terephthalate), and PI (polyimide).

The conductive layer 12 functions to conduct photo-generated carriers; a material of the conductive layer 12 may be selected from one or a combination of FTO (fluorine-doped tin oxide), ITO (indium tin oxide), and AZO (aluminum-doped zinc oxide). Among these, FTO (fluorine-doped tin oxide) provides conductivity while filtering ultraviolet light that could damage the perovskite layer 30.

The embodiments of this application use FTO conductive glass as an example for the first electrode layer 10; configurations where the first electrode layer 10 is of other types are similar and not repeated herein.

The first carrier transport layer 20 can transport holes and block electrons; a material of the first carrier transport layer 20 may be selected from one or a combination of 2,2',7,7'-tetrakis[N,N-di(4-methoxyphenyl)amino]-9,9'-spirobifluorene (Spiro-OMeTAD), poly(triarylamine) (PTAA), NiOx, poly(3,4-ethylenedioxythiophene):polystyrene sulfonate (PEDOT:PSS), and WO3.

The first functional layer 50 being capable of reflecting at least a portion of light incident from the first electrode layer 10 and transmitted through the perovskite layer 30 back to the perovskite layer 30 means that light not fully absorbed by the perovskite layer 30, after passing through the second carrier transport layer 40 to reach the first functional layer 50, has at least a portion reflected by the first functional layer 50 back to the perovskite layer 30, where the light is reabsorbed by the perovskite layer 30, significantly improving the utilization efficiency of incident light.

A material of the second electrode layer 60 may be one or a combination of Au, Ag, Cu, Al, Ni, Cr, Bi, Pt, Mg, MoO3, ITO, FTO, and AZO.

In the embodiments of this application, in steps S20 and S30, forming the perovskite layer 30 on a side of the first carrier transport layer 20 facing away from the first electrode layer 10 and forming the first functional layer 50 on a side of the perovskite layer 30 facing away from the first electrode layer 10 specifically include: forming the perovskite layer 30 on a side of the first carrier transport layer 20 facing away from the first electrode layer 10 and forming the first functional layer 50 on the perovskite layer 30.

In some other examples, in steps S20 and S30, forming the perovskite layer 30 on a side of the first carrier transport layer 20 facing away from the first electrode layer 10 and forming the first functional layer 50 on a side of the perovskite layer 30 facing away from the first electrode layer 10 specifically include: sequentially forming the perovskite layer 30, a second carrier transport layer 40, a second electrode layer 60, and the first functional layer 50 on a side of the first carrier transport layer 20 facing away from the first electrode layer 10.

In some other examples, in steps S20 and S30, forming the perovskite layer 30 on a side of the first carrier transport layer 20 facing away from the first electrode layer 10 and forming the first functional layer 50 on a side of the perovskite layer 30 facing away from the first electrode layer 10 specifically include: sequentially forming the perovskite layer 30, a second carrier transport layer 40, the first functional layer 50, and a second electrode layer 60 on a side of the first carrier transport layer 20 facing away from the first electrode layer 10, as shown in FIG. 1.

Understandably, when the first functional layer 50 is disposed between the second carrier transport layer 40 and the second electrode layer 60, the first functional layer 50 can prevent reactions between the second electrode layer 60 and the second carrier transport layer 40, improving interface contact and reducing charge accumulation at the interface. During the preparation process, the first functional layer 50 also protects the preceding second carrier transport layer 40, preventing degradation due to reactions with water or oxygen in the environment, thus improving the long-term stability of the perovskite battery 100.

In the embodiments of this application, the step of forming the first functional layer 50 on the second carrier transport layer 40 specifically includes:
depositing a LiF layer or a MgF2 layer on the second carrier transport layer 40 using a vacuum thermal evaporation method to form the first functional layer 50; or depositing an Al2O3 layer on the second carrier transport layer 40 using an atomic layer deposition method to form the first functional layer 50; or depositing a NiOx layer on the second carrier transport layer 40 using a magnetron sputtering method to form the first functional layer 50.

By forming the first functional layer 50 using the above materials, the first functional layer 50 can reflect light not fully utilized by the perovskite layer 30 back to the perovskite layer 30, thereby improving light utilization efficiency. Additionally, the first functional layer 50 maintains stable properties, isolating the second carrier transport layer 40 material from water, oxygen, and dust in the environment and preventing contact reactions, thus enhancing the stability of the perovskite battery 100.

Methods for forming the first functional layer 50 include, but are not limited to, spin coating, evaporation physical vapor deposition, sputtering physical vapor deposition, and atomic layer deposition.

According to some embodiments of this application, in step S20, forming the perovskite layer 30 on a side of the first carrier transport layer 20 facing away from the first electrode layer 10 may involve directly forming the perovskite layer 30 on the first carrier transport layer 20, or forming other intermediate functional layers on the first carrier transport layer 20 and then forming the perovskite layer 30 on these intermediate functional layers.

The step of forming the perovskite layer 30 on the first carrier transport layer 20specifically includes:
spin-coating a perovskite precursor solution onto the first carrier transport layer 20 to form an intermediate film layer of perovskite; and
covering a cavity 731 of a first mold 70 over the intermediate film layer of perovskite, and annealing and cooling the intermediate film layer of perovskite to form the perovskite layer 30 with a rough surface.

In the above solution, forming the intermediate film layer of perovskite on the first carrier transport layer 20, and covering the intermediate film layer of perovskite with the cavity 731 of the first mold 70, and annealing and cooling the intermediate film layer to form the perovskite layer 30 with a rough surface not only involves low cost but also features a relatively simple preparation process that is easy to implement.

Additionally, forming a rough surface on a surface of the perovskite layer 30 creates a structure with undulating heights on the surface of the perovskite layer 30; compared to a planar structure, this increases a surface area of the perovskite layer 30 on a side facing away from the first carrier transport layer 20, enlarging an absorption area for light incident on the perovskite layer 30, thereby increasing light utilization efficiency and improving the photoelectric conversion efficiency of the perovskite battery 100.

Spin-coating the perovskite precursor solution onto the first carrier transport layer 20 forms an intermediate film layer of perovskite on the first carrier transport layer 20 as a wet film; at this point, covering the intermediate film layer of perovskite with the cavity 731 of the first mold 70, followed by annealing and cooling the wet film, enables the formation of a rough surface on the perovskite layer.

In the embodiments of this application, the cavity 731 of the first mold 70 has a plurality of protrusions 71; For example, the protrusions 71 protrude along a thickness direction of the intermediate film layer of perovskite. Further, the step of covering the cavity 731 of the first mold 70 over the intermediate film layer of perovskite, and annealing and cooling the intermediate film layer of perovskite to form the perovskite layer 30 with a rough surface specifically includes:
covering the cavity 731 of the first mold 70 over the intermediate film layer of perovskite, where the protrusions 71 are embedded into the intermediate film layer of perovskite; and annealing and cooling the intermediate film layer of perovskite; and removing the first mold 70 from the intermediate film layer of perovskite to form the perovskite layer 30 with a plurality of recessed structures 31, where the recessed structures 31 correspond one-to-one with the plurality of protrusions 71.

In this manner, forming the recessed structures 31 on a surface of the perovskite layer 30 results in portions not recessed becoming protruding structures relative to the recesses, thereby forming a rough surface with undulating heights on the surface of the perovskite layer 30.

According to some embodiments of this application, a spin-coating speed is 4000 rpm, and a spin-coating duration is 20s; and/or an annealing duration is 45 min, and an annealing temperature is 120°C.

The intermediate film layer of perovskite formed by spin-coating the perovskite precursor solution onto the first carrier transport layer 20 is a wet film; by setting the spin-coating speed to 4000 rpm, the spin-coating duration to 20s, and/or the annealing duration to 45 min, and the annealing temperature to 120°C, the formation of the recessed structures 31 is facilitated.

According to some embodiments of this application, the step of covering the cavity 731 of the first mold 70 over the intermediate film layer of perovskite specifically includes:
covering the cavity 731 of the first mold 70 over the intermediate film layer of perovskite under vacuum conditions, where this not only facilitates the smooth formation of the recessed structures 31 but also aids the film formation process of the perovskite layer 30.

According to some embodiments of this application, as mentioned earlier, in steps S20 and S30, forming the perovskite layer 30 on a side of the first carrier transport layer 20 facing away from the first electrode layer 10 and forming the first functional layer 50 on a side of the perovskite layer 30 facing away from the first electrode layer 10 specifically include: sequentially forming the perovskite layer 30, a second carrier transport layer 40, the first functional layer 50, and a second electrode layer 60 on a side of the first carrier transport layer 20 facing away from the first electrode layer 10.

Specifically, the step of forming the second electrode layer 60 on the first functional layer 50 specifically includes:
forming a second functional layer 61 on the first functional layer 50; and
forming a first metal layer 62 on the second functional layer 61.

In the above solution, by forming the second functional layer 61 on the first functional layer 50 and forming the first metal layer 62 on the second functional layer 61, the second functional layer 61 is positioned between the first functional layer 50 and the first metal layer 62, thereby positioning the second functional layer 61 to block between the perovskite layer 30 and the first metal layer 62.

Due to the good conductivity and stable properties of the second functional layer 61, migration of iodine ions from the perovskite layer 30 to the first metal layer 62 is prevented, avoiding decomposition and failure of the perovskite battery 100; additionally, the first metal layer 62 serves the function of charge transport, thus effectively preventing reactions between the second electrode layer 60 and iodine ions in the perovskite layer 30 that could lead to failure of the perovskite battery 100 while ensuring charge transport.

The second functional layer 61 may be an inorganic compound layer, and a material of the second functional layer 61 may include at least one of the following materials: ITO, FTO, LiF, MgF2, and MoO3.

By adopting the above materials, the stability of the second functional layer 61 is enhanced, effectively preventing migration of iodine ions from the perovskite layer 30, reducing defects and recombination sites at the interface, and improving efficiency while increasing the long-term stability of the perovskite battery 100.

According to some embodiments of this application, optionally, a thickness of the second functional layer 61 ranges from 5 nm to 30 nm.

With such a thickness, the second functional layer 61 not only effectively blocks iodine ions in the perovskite layer 30 but also does not affect the charge transport process from the perovskite layer 30 to the first metal layer 62.

According to some embodiments of this application, optionally, a material of the first metal layer 62 may be a metal material, including but not limited to Ag, Cu, Au, Al, Ni, and Cr.

According to some embodiments of this application, optionally, the step of forming the second functional layer 61 on the first functional layer 50 specifically includes:
depositing a LiF layer or an ITO layer on the first functional layer 50 using a vacuum thermal evaporation method to form an inorganic compound layer.

Using a LiF layer or an ITO layer for the second functional layer 61 enhances the stability of the second functional layer 61, effectively preventing migration of iodine ions from the perovskite layer 30, reducing defects and recombination sites at the interface, and improving efficiency while increasing the long-term stability of the perovskite battery 100.

Several specific examples are provided below to illustrate the preparation method of the perovskite battery 100 in the embodiments of this application.

### Example 1:

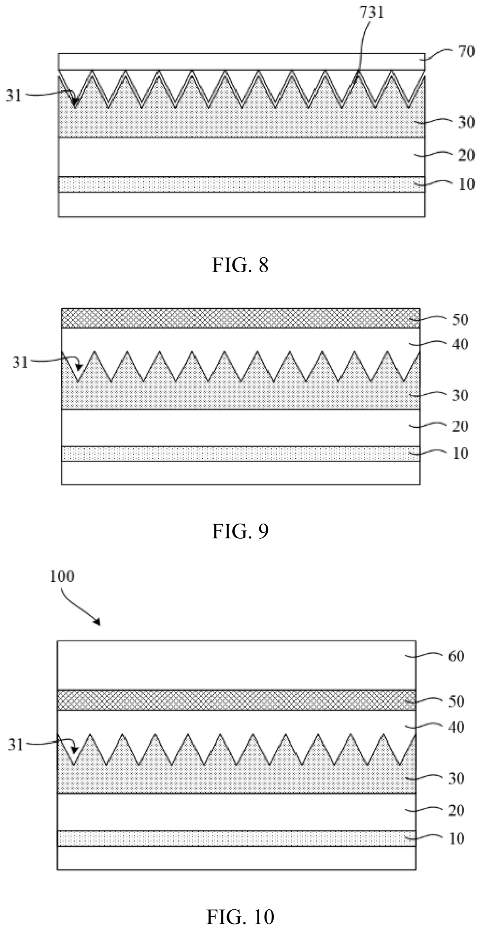

FIG. 7 is a schematic diagram of forming a first carrier transport layer on a first electrode layer in a preparation method of a perovskite battery according to some embodiments of this application, FIG. 8 is a schematic diagram of forming a perovskite layer on a first carrier transport layer in a preparation method of a perovskite battery according to some embodiments of this application, FIG. 9 is a schematic diagram of sequentially forming a second carrier transport layer and a first functional layer on a perovskite layer in a preparation method of a perovskite battery according to some embodiments of this application, and FIG. 10 is a schematic diagram of forming a second electrode layer on a first functional layer in a preparation method of a perovskite battery according to some embodiments of this application.

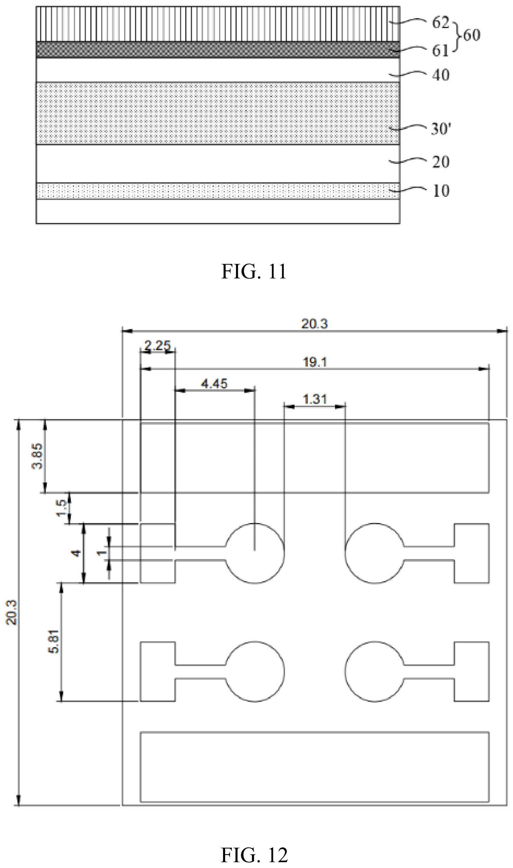

The preparation method of the perovskite battery 100 included the following steps:
(A) Referring to FIG. 7, a FTO conductive glass with a size of 2 x 2 cm was provided; and laser etching was applied to a local region of the FTO conductive glass to remove the FTO in the local region, forming an insulating region on the FTO conductive glass. The glass was ultrasonicated sequentially with deionized water, detergent, ethanol, isopropanol, acetone, ethanol, and deionized water for 20 min each, then dried with N2 for use, forming a clean first electrode layer 10.
(B) A NiOx nanoparticle solution was spin-coated onto the 2 x 2 cm first electrode layer 10 prepared in step (A) at a speed of 3000 rpm, annealing was performed at 200°C for 15 min. Upon natural cooling for use, a first carrier transport layer 20 with a thickness of 15 nm was formed.
(C) A perovskite precursor solution of FA0.9Cs0.1PbI3 with a concentration of 1 M was prepared, using DMF (N,N-dimethylformamide) as a solvent; and stirred to form the perovskite precursor solution and sealed for use.
(D) Referring to FIG. 8, the first electrode layer 10 with the first carrier transport layer 20 prepared in step (B) was treated with ultraviolet ozone for 15 min, and the surface was purged clean. Then, the perovskite precursor solution prepared in step (C) was taken and spin-coated onto the purged first carrier transport layer 20 at a speed of 4000 rpm for 20s to prepare an intermediate film layer of perovskite, namely a perovskite wet film; after evacuating for 30s, the intermediate film layer of perovskite was covered with a cavity 731 of a first mold 70, annealed on a hot plate at 120°C for 45 min, and naturally cooled to obtain a perovskite layer 30 with a plurality of recessed structures 31. The first mold 70 had a size of 2 x 2 cm, an inverted cone structure height h2 less than 100 nm, and a base edge length less than 100 nm; specifically, the mold used had an inverted cone height of 60 nm and a base edge length of 80 nm. The perovskite layer had a thickness of 500 nm, with h1 less than 100 nm, specifically h1 equal to 50 nm.
(E) Referring to FIG. 9, a PCBM (phenyl-C61-butyric acid methyl ester)/BCP (bathocuproine) solution was spin-coated onto the perovskite layer 30 formed in step (D) at a speed of 3000 rpm to form a second carrier transport layer 40. The thickness of PCBM was 20 nm, and the thickness of BCP was 7 nm.
(F) Still referring to FIG. 9, a LiF layer with a thickness of 1 nm was deposited on the second carrier transport layer 40 using a vacuum thermal evaporation method to form a first functional layer 50.
(G) Referring to FIG. 10, a Cu counter electrode was deposited on the first functional layer 50 formed in step (F) using a vacuum thermal evaporation method with a mask of a specific pattern as shown in FIG. 12 to form a second electrode layer 60. A thickness of the deposited Cu is 100 nm, and the unit of dimensions in FIG. 12 is mm.

The perovskite battery prepared through the above steps (A) to (G) was denoted as A1.

Upon further improvement of the above embodiment, step (F) could also be replaced with the following step:
A LiF layer with a thickness of 5 nm was deposited on the second carrier transport layer 40 using a vacuum thermal evaporation method to form a first functional layer 50; the perovskite battery prepared through steps (A) to (G) in this case was denoted as A2.

Alternatively, upon further improvement of the above embodiment, step (F) could also be replaced with the following step:
An Al2O3 layer with a thickness of 1 nm was deposited on the second carrier transport layer 40 using an atomic layer deposition method to form a first functional layer 50; the perovskite battery prepared through steps (A) to (G) in this case was denoted as A3.

Alternatively, upon further improvement of the above embodiment, step (F) could also be replaced with the following step:
A MgF2 layer with a thickness of 1 nm was deposited on the second carrier transport layer 40 using a vacuum thermal evaporation method to form a first functional layer 50; the perovskite battery prepared through steps (A) to (G) in this case was denoted as A4.

Alternatively, upon further improvement of the above embodiment, step (F) could also be replaced with the following step:
A NiOx layer with a thickness of 15 nm was deposited on the second carrier transport layer 40 using a magnetron sputtering method to form a first functional layer 50; the perovskite battery prepared through steps (A) to (G) in this case was denoted as A5.

Alternatively, upon further improvement of the above embodiment, step (F) could also be replaced with the following step:
A LiF layer with a thickness of 0.5 nm was deposited on the second carrier transport layer 40 using a vacuum thermal evaporation method to form a first functional layer 50; the perovskite battery prepared through steps (A) to (G) in this case was denoted as A6'.

Alternatively, upon further improvement of the above embodiment, step (F) could also be replaced with the following step:
A LiF layer with a thickness of 20 nm was deposited on the second carrier transport layer 40 using a vacuum thermal evaporation method to form a first functional layer 50; the perovskite battery prepared through steps (A) to (G) in this case was denoted as A7'.

### Comparative Example 1:

Step (F) was omitted from the above examples. Steps (A), (B), (C), (D), and (E) were performed. A Cu counter electrode was deposited on the second carrier transport layer 40 formed in step (E) using a vacuum thermal evaporation method with a mask of a specific pattern. The steps and parameters were the same as those for the perovskite battery A1, obtaining a perovskite battery denoted as C1.

Photoelectric conversion efficiency tests and stability tests were conducted on the perovskite batteries A1, A2, A3, A4, A5, A6', A7', and C1; and test results at time t1 were recorded in Table 1, and test results at time t2 were recorded in Table 2, where t1 < t2.

Voc represents open-circuit voltage; Jsc represents short-circuit current density; FF represents fill factor; and PCE represents photoelectric conversion efficiency.

**Table 1: Test results of performance tests for perovskite batteries A1, A2, A3, A4, A5, A6', A7', and C1 at time t1 (t1 being the initial stage, immediately after battery preparation, that is, t1 = 0):**

| Group | Voc (V) | Jsc (mA/cm²) | FF (%) | PCE (%) |
|---|---|---|---|---|
| A1 | 1.00 | 20.54 | 73.25 | 15.04 |
| A2 | 1.02 | 20.14 | 76.23 | 15.65 |
| A3 | 1.03 | 20.78 | 74.87 | 16.02 |
| A4 | 1.03 | 21.6 | 74.06 | 16.55 |
| A5 | 0.98 | 21.04 | 73.21 | 15.09 |
| A6' | 0.96 | 19.12 | 72.49 | 13.31 |
| A7' | 1.01 | 20.08 | 72.55 | 14.71 |
| C1 | 0.95 | 18.98 | 70.32 | 12.67 |

**Table 2: Test results of performance tests for perovskite batteries A1, A2, A3, A4, A5, A6', A7', and C1 at time t2 (t2 = 500 h):**

| Group | Voc (V) | Jsc (mA/cm²) | FF (%) | PCE (%) |
|---|---|---|---|---|
| A1 | 0.99 | 19.96 | 71.50 | 14.12 |
| A2 | 1.00 | 19.55 | 74.62 | 14.58 |
| A3 | 1.00 | 19.87 | 73.22 | 14.54 |
| A4 | 0.99 | 20.17 | 70.55 | 14.95 |
| A5 | 0.98 | 20.93 | 72.11 | 14.79 |
| A6' | 0.95 | 18.88 | 67.03 | 12.02 |
| A7' | 0.99 | 19.57 | 70.42 | 13.64 |
| C1 | 0.94 | 17.73 | 65.11 | 10.85 |

From Table 1 and Table 2, in the perovskite batteries A1, A2, A3, A4, A5, A6', and A7' provided with the first functional layer 50, the open-circuit voltage Voc, short-circuit current density Jsc, fill factor FF, and photoelectric conversion efficiency PCE were all higher than those of the perovskite battery C1 without the first functional layer 50. This indicates that in the perovskite battery 100 provided with the first functional layer 50, light utilization efficiency increases, improving the photoelectric conversion efficiency of the perovskite battery 100.

Furthermore, after a period (t2 - t1), such as 500 hours, the percentages of photoelectric conversion efficiency PCE relative to the initial time for the perovskite batteries A1, A2, A3, A4, A5, A6', and A7' provided with the first functional layer 50, and the perovskite battery C1 without the first functional layer 50, were respectively:
A1: 14.12/15.04 = 93.9%
A2: 14.58/15.65 = 93.2%
A3: 14.54/16.02 = 90.8%
A4: 14.95/16.55 = 90.3%
A5: 14.79/15.09 = 98%
A6': 12.02/13.31 = 90.3%
A7': 13.64/14.71 = 92.7%
C1: 10.85/12.67 = 85.6%

From the above calculation results, after a period (t2 - t1), the photoelectric conversion efficiency of the perovskite batteries A1, A2, A3, A4, A5, A6', and A7' provided with the first functional layer 50 remained above 90% of the initial value, with a decline less than that of the perovskite battery C1 without the first functional layer 50; this indicates that the long-term stability of the perovskite batteries A1, A2, A3, A4, A5, A6', and A7' provided with the first functional layer 50 surpasses that of the perovskite battery C1 without the first functional layer 50.

### Example 2:

FIG. 11 is a schematic structural diagram of a perovskite battery prepared by another preparation method according to some embodiments of this application.

Referring to FIG. 11, the preparation method of the perovskite battery 100 included the following steps:

(H) A FTO conductive glass with a size of 2 x 2 cm was provided; and laser etching was applied on a local region of the FTO conductive glass to remove the FTO in the local region, forming an insulating region on the FTO conductive glass. The glass was ultrasonicated sequentially with deionized water, detergent, ethanol, isopropanol, acetone, ethanol, and deionized water for 20 min each, then dried with N2 for use, forming a clean first electrode layer 10.

(I) A NiOx nanoparticle solution was spin-coated onto the 2 x 2 cm first electrode layer 10 prepared in step (H) at a speed of 3000 rpm, annealing was performed at 200°C for 15 min, followed by natural cooling for use, forming a first carrier transport layer 20 with a thickness of 15 nm.

(J) A perovskite precursor solution of FA0.9Cs0.1PbI3 with a concentration of 1 M was prepared, using DMF (N,N-dimethylformamide) as a solvent; and stirred to form the perovskite precursor solution and sealed for use.

(K) The first electrode layer 10 was treated with the first carrier transport layer 20 prepared in step (I) with ultraviolet ozone for 15 min, and the surface was purged clean. Then, the perovskite precursor solution prepared in step (J) was taken and spin-coated onto the purged first carrier transport layer 20 at a speed of 4000 rpm for 20s to prepare a perovskite wet film; after evacuating for 30s, annealing was performed on a 120°C hot plate for 45 min. Upon natural cooling, a first perovskite layer 30' with a thickness of 500 nm was obtained.

(L) A PCBM (phenyl-C61-butyric acid methyl ester)/BCP (bathocuproine) solution was spin-coated onto the first perovskite layer 30' formed in step (K) at a speed of 3000 rpm to form a second carrier transport layer 40. The thickness of PCBM was 25 nm, and the thickness of BCP was 7 nm.

(M) A LiF layer with a thickness of 10 nm was deposited on the second carrier transport layer 40 using a vacuum thermal evaporation method to form a second functional layer 61, and a Cu counter electrode with a thickness of 70 nm was deposited on the second functional layer 61 to form a first metal layer 62.

The perovskite battery prepared through the above steps (H) to (M) was denoted as A6.

Upon further improvement of the above embodiment, step (M) could also be replaced with the following step: A LiF layer with a thickness of 20 nm was deposited on the second carrier transport layer 40 using a vacuum thermal evaporation method to form a second functional layer 61, and a Cu counter electrode with a thickness of 60 nm was deposited on the second functional layer 61 to form a first metal layer 62; and the perovskite battery prepared through steps (H) to (M) in this case was denoted as A7.

Upon further improvement of the above embodiment, step (M) could also be replaced with the following step: An ITO layer with a thickness of 30 nm was deposited on the second carrier transport layer 40 using a vacuum thermal evaporation method to form a second functional layer 61, and a Cu counter electrode with a thickness of 40 nm was deposited on the second functional layer 61 to form a first metal layer 62; and the perovskite battery prepared through steps (H) to (M) in this case was denoted as A8.

Upon further improvement of the above embodiment, step (M) could also be replaced with the following step: An ITO layer with a thickness of 5 nm was deposited on the second carrier transport layer 40 using a magnetron sputtering method to form a second functional layer 61, and a Cu counter electrode with a thickness of 70 nm was deposited on the second functional layer 61 to form a first metal layer 62; and the perovskite battery prepared through steps (H) to (M) in this case was denoted as A9.

Additionally, components of the perovskite precursor solution are not limited to those listed in the above embodiments; the components may also be FA1-xCsxPb(Il-yBry), where 0 < x, y < 1, with a concentration of 0.8 M to 1.5 M, using a solvent of one or a mixture of two in a certain volume ratio from DMF (N,N-dimethylformamide), DMSO (dimethyl sulfoxide), and NMP (1-methyl-2-pyrrolidinone).

### Comparative Example 2:

Step (M) in the above embodiment was replaced with the following step:
A Cu counter electrode with a thickness of 70 nm was deposited on the second carrier transport layer 40 using a vacuum thermal evaporation method to form a second electrode layer 60. The perovskite battery prepared through steps (H) to (M) in this case was denoted as C2.

Photoelectric conversion efficiency tests and stability tests were conducted on the perovskite batteries A6, A7, A8, A9, and C2; and test results at time t3 were recorded in Table 3, and test results at time t4 in Table 4 were recorded in Table 4, where t3 < t4.

Voc represents open-circuit voltage; Jsc represents short-circuit current density; FF represents fill factor; and PCE represents photoelectric conversion efficiency.

**Table 3: Test results of performance tests for perovskite batteries A6, A7, A8, A9, and C2 at time t3:**

| Group | Voc (V) | Jsc (mA/cm²) | FF (%) | PCE (%) |
|---|---|---|---|---|
| A6 | 1.00 | 22.33 | 78.25 | 17.47 |
| A7 | 0.98 | 21.34 | 79.15 | 16.55 |
| A8 | 1.01 | 23.01 | 76.58 | 17.80 |
| A9 | 0.97 | 22.06 | 76.02 | 15.09 |
| C2 | 0.95 | 20.98 | 75.92 | 15.13 |

**Table 4: Test results of performance tests for perovskite batteries A6, A7, A8, A9, and C2 at time t4:**

| Group | Voc (V) | Jsc (mA/cm²) | FF (%) | PCE (%) |
|---|---|---|---|---|
| A6 | 0.99 | 22.16 | 75.80 | 16.63 |
| A7 | 0.98 | 21.09 | 77.65 | 16.05 |
| A8 | 1.00 | 22.95 | 75.98 | 17.43 |
| A9 | 0.95 | 21.08 | 71.68 | 14.35 |
| C2 | 0.94 | 19.55 | 70.32 | 12.92 |

From Table 3 and Table 4, in the perovskite batteries A6, A7, A8, and A9 provided with the second functional layer 61, the open-circuit voltage Voc, short-circuit current density Jsc, fill factor FF, and photoelectric conversion efficiency PCE were all higher than those of the perovskite battery C2 without the second functional layer 61. This indicates that in the perovskite battery provided with the second functional layer 61, light utilization efficiency increases, improving the photoelectric conversion efficiency of the perovskite battery.

Furthermore, after a period (t4 - t3), such as 500 hours, the percentages of photoelectric conversion efficiency PCE relative to the initial time for the perovskite batteries A6, A7, A8, and A9 provided with the second functional layer 61, and the perovskite battery C2 without the second functional layer 61, were respectively:
A6: 16.63/17.47 = 95.2%
A7: 16.05/16.55 = 97.0%
A8: 17.43/17.80 = 97.9%
A9: 14.35/15.09 = 95.1%
C2: 12.92/15.13 = 85.4%

From the above calculation results, after a period (t4 - t3), the decline in photoelectric conversion efficiency of the perovskite batteries A6, A7, A8, and A9 provided with the second functional layer 61 was less than that of the perovskite battery C2 without the second functional layer 61; this indicates that the stability of the perovskite batteries A6, A7, A8, and A9 provided with the second functional layer 61 surpasses that of the perovskite battery C2 without the second functional layer 61.

The technical features of the above-described embodiments can be combined arbitrarily; to keep the description concise, not all possible combinations of the technical features in the above embodiments are described. However, as long as no contradiction exists in the combination of these technical features, all should be considered within the scope recorded in this specification.

The foregoing embodiments represent only several implementations of this application, with specific and detailed descriptions, but should not be construed as limiting the scope of this patent. It should be noted that for persons of ordinary skill in the art, several variations and improvements can be made without departing from the concept of this application, all of which fall within the protection scope of this application. Therefore, the protection scope of this patent application shall be subject to the appended claims.

## Claims

1. A perovskite battery comprising:
a first electrode layer configured to be an electrode layer for light incidence in the perovskite battery;
a first carrier transport layer disposed on the first electrode layer, the first carrier transport layer being one of a hole transport layer and an electron transport layer;
a perovskite layer disposed on a side of the first carrier transport layer facing away from the first electrode layer;
a second electrode layer located on a side of the perovskite layer facing away from the first electrode layer; and
a first functional layer located on a side of the perovskite layer facing away from the first electrode layer and on a side of the second electrode layer in a thickness direction, wherein the first functional layer is capable of reflecting at least a portion of light incident from the first electrode layer and transmitted through the perovskite layer back to the perovskite layer.

2. The perovskite battery according to claim 1, wherein a material of the first functional layer comprises at least one of the following materials:
TiO2, ZnO, SnO2, Al2O3, MoO3, WO3, NiOx, ITO, FTO, AgBiS2, WS2, MoS2, LiF, MgF2, NaF, KF, Au, Ag, Cu, Al, and Cr.

3. The perovskite battery according to claim 1 or 2, wherein a thickness of the first functional layer ranges from 0.5 nm to 20 nm.

4. The perovskite battery according to any one of claims 1 to 3, wherein the perovskite battery further comprises a second carrier transport layer disposed between the perovskite layer and the second electrode layer, wherein the second carrier transport layer is the other of the hole transport layer and the electron transport layer;
wherein the first functional layer is disposed between the perovskite layer and the second carrier transport layer; or
the first functional layer is disposed between the second carrier transport layer and the second electrode layer; or the first functional layer is disposed on a side of the second electrode layer facing away from the second carrier transport layer; or
the first functional layer is disposed both between the perovskite layer and the second carrier transport layer and between the second carrier transport layer and the second electrode layer; or
the first functional layer is disposed both between the perovskite layer and the second carrier transport layer and on a side of the second electrode layer facing away from the second carrier transport layer; or
the first functional layer is disposed both between the second carrier transport layer and the second electrode layer and on a side of the second electrode layer facing away from the second carrier transport layer; or
the first functional layer is disposed between the perovskite layer and the second carrier transport layer, between the second carrier transport layer and the second electrode layer, and on a side of the second electrode layer facing away from the second carrier transport layer.

5. The perovskite battery according to claim 4, wherein the first functional layer is disposed between the second carrier transport layer and the second electrode layer; wherein
the second electrode layer comprises a second functional layer and a first metal layer stacked on a side of the first functional layer facing away from the second carrier transport layer, wherein the second functional layer is configured to block migration of iodine ions from the perovskite layer to the first metal layer.

6. The perovskite battery according to claim 5, wherein a material of the second functional layer comprises at least one of the following materials:
ITO, FTO, LiF, MgF2, and MoO3.

7. The perovskite battery according to claim 5 or 6, wherein a thickness of the second functional layer ranges from 5 nm to 30 nm.

8. The perovskite battery according to any one of claims 1 to 7, wherein a surface of the perovskite layer on a side facing away from the first carrier transport layer is a rough surface.

9. The perovskite battery according to claim 8, wherein a surface of the perovskite layer on a side facing away from the first carrier transport layer is provided with a plurality of recessed structures.

10. The perovskite battery according to claim 9, wherein an inner contour shape of the recessed structures is an inverted pyramid shape.

11. The perovskite battery according to claim 9 or 10, wherein a depth h1 of the recessed structures satisfies: 0 < h1 ≤ 100 nm.

12. The perovskite battery according to any one of claims 9 to 11, wherein the plurality of recessed structures are arranged in an array.

13. An electric apparatus, wherein the electric apparatus comprises the perovskite battery according to any one of claims 1 to 12, the perovskite battery being configured to provide electrical energy.

14. A preparation method of a perovskite battery comprising:
forming a first carrier transport layer on a first electrode layer;
forming a perovskite layer on a side of the first carrier transport layer facing away from the first electrode layer; and
forming a first functional layer on a side of the perovskite layer facing away from the first electrode layer;
wherein the first carrier transport layer is one of a hole transport layer and an electron transport layer, the first electrode layer is configured to be an electrode layer for light incidence in the perovskite battery, and the first functional layer is capable of reflecting at least a portion of light incident from the first electrode layer and transmitted through the perovskite layer back to the perovskite layer.

15. The preparation method of a perovskite battery according to claim 14, wherein the forming a perovskite layer on a side of the first carrier transport layer facing away from the first electrode layer specifically comprises:
spin-coating a perovskite precursor solution onto the first carrier transport layer to form an intermediate film layer of perovskite; and
covering a cavity of a first mold over the intermediate film layer of perovskite, and annealing and cooling the intermediate film layer of perovskite to form the perovskite layer with a rough surface.

16. The preparation method of a perovskite battery according to claim 15, wherein a spin-coating speed is 4000 rpm, and a spin-coating duration is 20s; or
an annealing duration is 45 min, and an annealing temperature is 120°C; or
a spin-coating speed is 4000 rpm, a spin-coating duration is 20s, an annealing duration is 45 min, and an annealing temperature is 120°C.

17. The preparation method of a perovskite battery according to claim 15 or 16, wherein the cavity of the first mold is provided with a plurality of protrusions;
the covering a cavity of a first mold over the intermediate film layer of perovskite, and annealing and cooling the intermediate film layer of perovskite to form the perovskite layer with a rough surface specifically comprises:
covering the cavity of the first mold over the intermediate film layer of perovskite, wherein the protrusions are embedded into the intermediate film layer of perovskite;
annealing and cooling the intermediate film layer of perovskite; and
removing the first mold from the intermediate film layer of perovskite to form the perovskite layer with a plurality of recessed structures, wherein the recessed structures correspond one-to-one with the plurality of protrusions.
